# EUROPEAN PATENT APPLICATION

(11) **EP 2 623 648 A1**
(43) Date of publication of application: **07.08.2013**
(21) Application number: 11828523.8
(22) Date of filing: 07.05.2011
(51) Int. Cl.: C30B 29/38, H01L 21/205

(54) **GROWTH METHOD FOR GAN CRYSTAL AND GAN CRYSTAL SUBSTRATE**

(30) Priority: 27.09.2010 JP 2010215164
(71) Applicant: Sumitomo Electric Industries, Ltd., Chuo-ku Osaka-shi Osaka 541-0041 (JP)
(72) Inventor: FUJIWARA, Shinsuke, Itami-shi Hyogo 664-0016 (JP); UEMATSU, Koji, Itami-shi Hyogo 664-0016 (JP); OSADA, Hideki, Itami-shi Hyogo 664-0016 (JP)
(74) Representative: Grünecker, Kinkeldey, Stockmair & Schwanhäusser
(86) International application number: PCT/JP2011/060611
(87) International publication number: WO 2012/042961

(57) **Abstract**

The present invention is to provide GaN crystal growing method for growing a GaN crystal with few stacking faults on a GaN seed crystal substrate having a main surface inclined at an angle of 20° to 90° from the (0001) plane, and also to provide a GaN crystal substrate with few stacking faults. A method for growing a GaN crystal includes the steps of preparing a GaN seed crystal substrate 10 having a main surface 10m inclined at an angle of 20° to 90° from a (0001) plane 10c and growing a GaN crystal 20 on the GaN seed crystal substrate 10. The GaN seed crystal substrate 10 and the GaN crystal 20 have a difference in impurity concentration of 3 × 10¹⁸ cm⁻³ or less.

## Description

### Technical Field

The present invention relates to methods for growing a GaN crystal having a main surface lying in a nonpolar plane (plane perpendicular to the (0001) plane) or a semipolar plane (plane inclined at an angle more than 0° and less than 90° from the (0001) plane), and also relates to GaN crystal substrates.

### Background Art

GaN crystals and GaN crystal substrates suitable for use in devices such as light-emitting devices, electronic devices, and semiconductor sensors are usually produced by growing a crystal on a main surface of a substrate, such as a sapphire substrate having a main surface lying in the (0001) plane or a GaAs substrate having a main surface lying in the (111 )A plane, by a vapor-phase process such as hydride vapor phase epitaxy (HVPE) or metal-organic chemical vapor deposition (MOCVD), or by a liquid-phase process such as flux method. Accordingly, a typical GaN crystal or GaN crystal substrate thus produced has a main surface lying in the (0001) plane.

A light-emitting device including a light-emitting layer of multiple-quantum well (MQW) structure formed on a main surface of a GaN crystal substrate lying in the (0001) plane has problems such as a shift in emission wavelength and a decrease in luminous efficiency because the polarity that the GaN crystal possesses in the <0001> direction results in spontaneous polarization in the light-emitting layer.

To solve such problems, GaN crystals and GaN crystal substrates having a main surface lying in a plane such as a nonpolar plane, where no polarization occurs, or a semipolar plane, where less polarization occurs, and methods for producing such crystals have been proposed.

For example, Japanese Unexamined Patent Application Publication No. 2002-373864 (*Patent Literature 1*) discloses that a GaN crystal is grown while maintaining a surface with a certain orientation other than the c-plane (such as the {11-20} plane (a-plane) or {1-100} plane (m-plane) in order to dope the GaN crystal with oxygen.

In addition, Japanese Unexamined Patent Application Publication No. 2006-315947 (*Patent Literature 2*) discloses that a large nitride semiconductor wafer (such as a GaN wafer) having low dislocation density is formed by arranging nitride semiconductor bars having a main surface lying in the m-plane and growing a nitride semiconductor layer on the main surfaces (m-plane) of the arranged nitride semiconductor bars.

In addition, Japanese Unexamined Patent Application Publication No. 2008-143772 (*Patent Literature 3*) discloses that a large, highly crystalline group III nitride crystal having a main surface with any particular planar orientation other than the {0001} plane is formed by arranging a plurality of group III nitride crystal substrates having a main surface with the above particular planar orientation so as to be adjacent to each other in the transverse direction and growing a group III nitride crystal on the main surfaces of the arranged group III nitride crystal substrates.

### Citation List

*Patent Literature 1* Japanese Unexamined Patent Application Publication No. 2002-373864
*Patent Literature 2* Japanese Unexamined Patent Application Publication No. 2006-315947
*Patent Literature 3* Japanese Unexamined Patent Application Publication No. 2008-143772

### Summary of Invention

### Technical Problems

All of Japanese Unexamined Patent Application Publication Nos. 2002-373864 *(Patent Literature 1*), 2006-315947(*Patent Literature 2*), and 2008-143772(*Patent Literature 3*) above disclose a homoepitaxy process in which a GaN crystal is grown on a GaN seed crystal substrate having a main surface with a planar orientation other than the c-plane ((0001) plane). It has been believed in the art that no stacking faults occur during homoepitaxy.

However, the present inventors have found that even homoepitaxy causes stacking faults if the crystal is grown on a surface with a planar orientation other than the c-plane, although the density thereof is low, namely, less than 1 × 10³ cm⁻¹. These stacking faults cannot be examined by a method typically used for examination of disiocations, such as cathode luminescence (CL) or etching, and if the density is low, they are difficult to examine even by transmission electron microscopy (TEM). Hence, the present inventors used low-temperature CL for the examination.

Accordingly, it is an object of the present invention to provide a method for growing a GaN crystal with few stacking faults on a GaN seed crystal substrate having a main surface inclined at an angle of 20° to 90° from the (0001) plane, and also to provide a GaN crystal substrate with few stacking faults.

### Solution to Problems

A method for growing a GaN crystal according to an aspect of the present invention includes the steps of preparing a GaN seed crystal substrate having a main surface inclined at an angle of 20° to 90° from a (0001) plane and growing a GaN crystal on the GaN seed crystal substrate. The GaN seed crystal substrate and the GaN crystal have a difference in impurity concentration of 3 × 10¹⁸ cm⁻³ or less.

In the method for growing a GaN crystal according to the above aspect of the present invention, the main surface of the GaN seed crystal substrate may be inclined at an angle of 43° to 90° from the (0001) plane. In addition, the GaN seed crystal substrate and the GaN crystal may have a difference in impurity concentration of 1 × 10¹⁸ cm⁻³ or less. In addition, the impurity concentration of the GaN seed crystal substrate and the GaN crystal may be oxygen atom concentration. In addition, the stacking fault density in the main surface of the GaN seed crystal substrate may be 100 cm⁻¹ or less, and the radius of curvature of the (0001) plane may be 5 m or more. A GaN crystal substrate according to another aspect of the present invention is cut from the GaN crystal grown by the above method for growing a GaN crystal. The GaN crystal substrate may have a main surface inclined at an angle of 20° to 90° from a (0001) plane, and the stacking fault density in the main surface may be 100 cm⁻¹ or less.

### Advantageous Effects of Invention

According to the above aspects of the present invention, there can be provided a method for growing a GaN crystal with few stacking faults on a GaN seed crystal substrate having a main surface inclined at an angle of 20° to 90° from the (0001) plane and a GaN crystal substrate with few stacking faults.

### Brief Description of Drawings

Figure 1A is a schematic sectional view showing a method for growing a GaN crystal according to an embodiment of the present invention, illustrating a step of preparing a GaN seed crystal substrate.
Figure 1B is a schematic sectional view showing the method for growing a GaN crystal according to the embodiment of the present invention, illustrating a step of growing a GaN crystal.
Figure 1C is a schematic sectional view showing the method for growing a GaN crystal according to the embodiment of the present invention, illustrating a step of cutting a GaN crystal substrate from the GaN crystal.
Figure 2 is a schematic sectional view showing an example of a crystal growth apparatus used in the method for growing a GaN crystal according to the embodiment of the present invention.

### Description of Embodiments

### First Embodiment

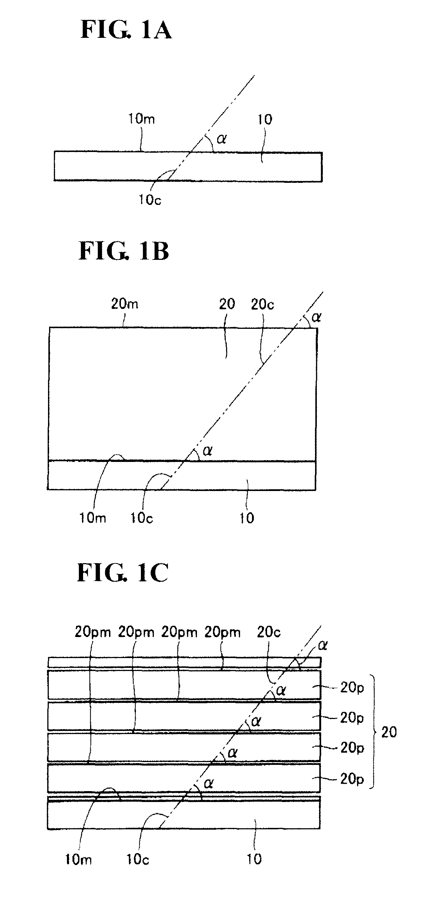

Referring to Figs. 1A to 1C, a method for growing a GaN crystal according to an embodiment of the present invention includes a step of preparing a GaN seed crystal substrate 10 having a main surface 10m inclined at an angle of 20° to 90° from a (0001) plane 10c (Fig. 1 A) and a step of growing a GaN crystal 20 on the GaN seed crystal substrate 10 (Fig. 1B). A difference in impurity concentration between the GaN seed crystal substrate 10 and the GaN crystal 20 is 3 × 10¹⁸ cm⁻³ or less.

The method for growing a GaN crystal according to this embodiment, in which the GaN crystal 20 is grown on the main surface 10m, inclined at an angle of 20° to 90° from the (0001) plane 10c, of the GaN seed crystal substrate 10, inhibits stacking faults in the GaN crystal 20 by making a difference of 3 × 10¹⁸ cm⁻³ or less in impurity concentration between the GaN seed crystal substrate 10 and the GaN crystal 20. The individual steps will now be described in detail.

### Step of Preparing GaN Seed Crystal Substrate

Referring to Fig. 1A, the method for growing a GaN crystal according to this embodiment includes the step of preparing the GaN seed crystal substrate 10 having the main surface 10m inclined at an angle of 20° to 90° from the (0001) plane 10c. The GaN crystal 20 can be grown on the main surface 10m of the GaN seed crystal substrate 10 such that the crystal growth surface is a main surface having the same planar orientation as the main surface 10m.

The angle α at which the main surface 10m of the GaN seed crystal substrate 10 is inclined from the (0001) plane is set to 20° to 90° to obtain a GaN crystal and GaN crystal substrate having a main surface with a polarity low enough to reduce, for example, a shift in emission wavelength and a decrease in luminous efficiency of semiconductor devices. From this viewpoint, the main surface 10m of the GaN seed crystal substrate 10 is preferably inclined at an angle α of 43° to 90° from the (0001) plane 10c.

To grow a GaN crystal 20 whose stacking fault density is low or zero, the stacking fault density in the main surface 10m of the GaN seed crystal substrate 10 is preferably 100 cm⁻¹ or less, more preferably 10 cm⁻¹ or less, further preferably 1 cm⁻¹ or less, and most preferably 0 cm⁻¹. The stacking fault density in the main surface 10m of the GaN seed crystal substrate 10 is measured by low-temperature CL on the main surface 10m.

To grow a GaN crystal 20 whose stacking fault density is low or zero, additionally, the radius of curvature of the (0001) plane 10c of the GaN seed crystal substrate 10 is preferably 5 m or more, more preferably 10 m or more, and further preferably 20 m or more. The radius of curvature of the (0001) plane 10c is measured by X-ray diffractometry.

The GaN seed crystal substrate 10 having the main surface 10m inclined at an angle α of 20° to 90° from the (0001) plane 10c may be prepared by any method. To prepare a GaN seed crystal substrate 10 whose stacking fault density is low or zero, a GaN mother crystal is grown such that the crystal growth surface is the (0001) plane, and a GaN seed crystal substrate 10 is preferably cut from the GaN mother crystal along a plane inclined at an angle α of 20° to 90° from the (0001) plane.
From the same viewpoint, as described later, it is also preferable to use a GaN crystal substrate obtained by the present invention as the GaN seed crystal substrate 10.

### Step of Growing GaN Crystal

Referring to Fig. 1B, the method for growing a GaN crystal according to this embodiment includes the step of growing the GaN crystal 20 on the GaN seed crystal substrate 10, specifically, on the main surface 10m of the GaN seed crystal substrate 10. The GaN crystal 20 grows on the main surface 10m of the GaN seed crystal substrate 10 such that the crystal growth surface is a main surface 20m having the same planar orientation as the main surface 10m.

The GaN crystal 20 may be grown by any homoepitaxy process in which a GaN crystal is grown on the main surface 10m of the GaN seed crystal substrate 10, for example, by a vapor-phase process such as hydride vapor phase epitaxy (HVPE), metal-organic chemical vapor deposition (MOCVD), molecular beam epitaxy (MBE), or sublimation method, or by a liquid-phase process such as flux method. HVPE is preferred because a thick crystal can be efficiently grown at high rate.

In the step of growing the GaN crystal 20, the GaN seed crystal substrate 10 and the GaN crystal 20 have a difference in impurity concentration of 3 × 10¹⁸ cm⁻³ or less. If the GaN seed crystal substrate 10 and the GaN crystal 20 grown on the main surface 10m of the GaN seed crystal substrate 10 have a difference in impurity concentration of 3 × 10¹⁸ cm⁻³ or less, the GaN crystal has few stacking faults. From this viewpoint, the GaN seed crystal substrate 10 and the GaN crystal 20 preferably have a difference in impurity concentration of I × 10¹⁸ cm⁻³ or less. The impurity concentrations of the GaN seed crystal substrate 10 and the GaN crystal 20 are measured by secondary ion mass spectrometry (SIMS).

The mechanism by which the difference in impurity concentration between the GaN seed crystal substrate 10 and the GaN crystal 20 affects the formation of stacking faults is not fully understood. Presumably, a considerable difference in impurity concentration between the GaN seed crystal substrate and the GaN crystal varies the lattice constants of the GaN crystal 20 being grown, causing stacking faults in such a way as to relax a stress resulting from the difference in the lattice constant in the c-axis direction (<0001> direction).

The above impurity concentration of the GaN seed crystal substrate 10 and the GaN crystal 20 is preferably oxygen atom concentration. That is, the oxygen atom concentration of the GaN seed crystal substrate 10 differs from that of the GaN crystal 20 by 3 × 10¹⁸ cm⁻³ or less preferably, by 1 × 10¹⁸ cm⁻³ or less more preferably.

If the GaN crystal 20 is grown on the main surface 10m of the GaN seed crystal substrate 10 inclined at an angle α of 20° to 90° from the (0001) plane, the GaN crystal grows such that the crystal growth surface is the main surface 20m having the same planar orientation as the main surface 10m. If the GaN crystal 20 is grown such that the crystal growth surface is the main surface 20m, it is extremely easily contaminated with oxygen atoms as an impurity. If the GaN crystal is grown in this way without any special care, it has an oxygen atom concentration of about 5 × 10¹⁸ cm⁻³ or more. On the other hand, if the GaN crystal 20 is grown such that the crystal growth surface is the (0001) plane, it is not easily contaminated with oxygen atoms as an impurity. If the GaN crystal is grown in this way without any special care, it has an oxygen atom concentration of about 1 × 10¹⁷ cm⁻³ or less.

To inhibit stacking faults in the GaN crystal 20 grown on the main surface 10m, inclined at an angle α of 20° to 90° from the (0001) plane, of a GaN seed crystal substrate 10 cut from a GaN mother crystal grown such that the crystal growth surface is the (0001) plane and having low impurity concentration, for example, low oxygen atom concentration, and low stacking fault density, it is important how to prevent the GaN crystal 20 from being contaminated with oxygen atoms during the growth of the GaN crystal 20 so that the GaN seed crystal substrate 10 and the GaN crystal 20 have a difference in impurity concentration (particularly, oxygen atom concentration) of 3 × 10¹⁸ cm⁻³ or less, preferably I × 10¹⁸ cm⁻³ or less.

As described above, it is known that if the GaN crystal 20 is grown on the main surface 10m of the GaN seed crystal substrate 10 inclined at an angle α of 20° to 90° from the (0001) plane, it is extremely easily contaminated with oxygen atoms as an impurity.

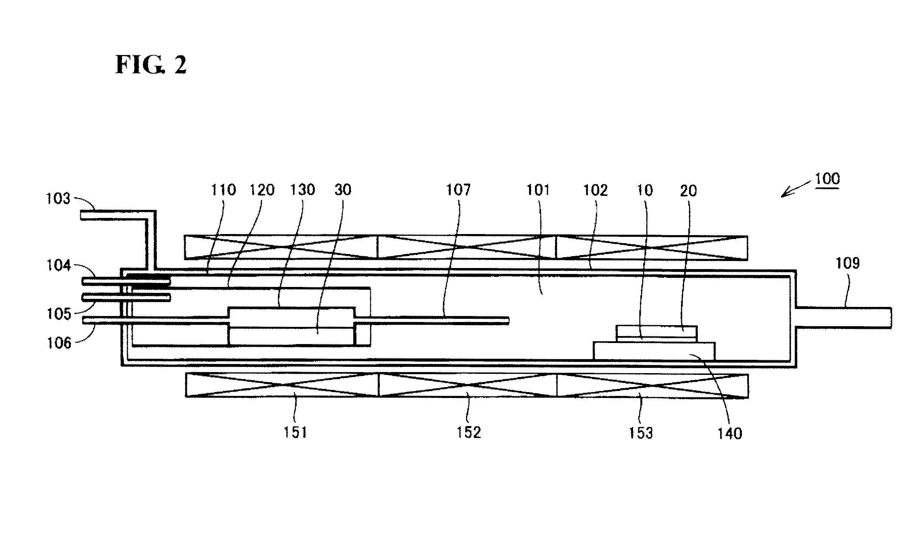

Referring to Fig. 2, an HVPE apparatus 100 used for growing a GaN crystal by HVPE has a reaction chamber 101 formed by a reaction tube 102, which is usually formed of quartz glass. Impurity gas emitted from the reaction tube 102 is the source of oxygen atoms that contaminate the GaN crystal as an impurity. To reduce the impurity concentration (particularly, oxygen atom concentration) of the GaN crystal, therefore, the HVPE apparatus 100 used in the method for growing a GaN crystal according to this embodiment and the method for growing a GaN crystal using the HVPE apparatus 100 have the following features.

(1) A first liner tube 110 formed of high-purity (for example, 99.999% by mass or more) pyrolytic boron nitride (pBN) is disposed within the reaction tube 102. If the GaN seed crystal substrate 10 is placed in the first liner tube 110, it can prevent the impurity gas emitted from the reaction tube 102 from coming into contact with the GaN crystal 20 grown on the GaN seed crystal substrate 10.

(2) As a first purge gas, a high-purity (for example, 99.9999% by mass or more) nitrogen gas is allowed to flow between the reaction tube 102, formed of quartz glass, and the first liner tube 110, formed of pBN, through a first purge gas introduction pipe 103 disposed on the reaction tube 102. With the first purge gas, the impurity gas emitted from the reaction tube 102 can be discharged outside the reaction chamber 101 through a gas discharge pipe 109.

(3) A susceptor 140 supporting the GaN seed crystal substrate 10 disposed within the first liner tube formed of pBN, has a local heating mechanism. This local heating mechanism allows the heating temperature of heaters 151, 152, and 153 for heating the reaction tube 102, formed of quartz glass and forming the reaction chamber 101, to be lowered while locally maintaining the GaN seed crystal substrate 10 in the reaction chamber 101 and the vicinity thereof at the desired temperature, thus reducing the impurity gas emitted from the reaction tube 102. In addition, the local heating mechanism may be of any type that can locally heat the GaN seed crystal substrate 10 and the vicinity thereof to the desired temperature, such as a resistance heating mechanism such as a heater, a highfrequency heating mechanism, or a lamp heating mechanism.

(4) The surface of the susceptor 140 having the local heating mechanism is coated with pBN. This prevents emission of impurity gas from the susceptor 140 and contamination of the GaN crystal with impurity gas.

(5) The temperature at which a gallium source boat 130 formed of quartz glass is heated is lowered. This inhibits emission of impurity gas from the gallium source boat 130.

(6) Nitrogen (N₂) gas is used instead of hydrogen (H₂) gas as a carrier gas for a chlorine-containing gas introduced into the gallium source boat 130 through a chlorine-containing gas introduction pipe 106. This inhibits emission of impurity gas from the gallium source boat 130.

(7) The gallium source boat 130 is disposed in a second liner tube 120 disposed in the first liner tube and nitrogen (N₂) gas is used as a second purge gas introduced into the second liner tube 120 through a second purge gas introduction pipe 105. This inhibits decomposition of quartz glass at the surface thereof. The impurity concentration (particularly, oxygen atom concentration) of the GaN crystal grown can be adjusted depending on the concentration of H₂O gas added to the nitrogen gas.

(8) Ammonia (NH₃) gas, serving as a nitrogen source gas, and hydrogen (H₂) gas and nitrogen (N₂) gas, serving as carrier gases, are introduced into the first liner tube 110 through a nitrogen source gas introduction pipe 104 via the space between the first liner tube 110 and the second finer tube 120. The first liner tube 110 and the second liner tube 120 prevent the ammonia (NH₃) gas and hydrogen (H₂) gas, which are highly reactive with quartz glass, from coming into contact with the reaction tube 102 and the gallium source boat 130, which are formed of quartz glass.

By the HVPE process with the above features, the impurity concentration (particularly, oxygen atom concentration) of the GaN crystal 20 can be adjusted such that the GaN seed crystal substrate 10 and the GaN crystal 20 have a difference in impurity concentration (particularly, oxygen atom concentration) of 3 × 10¹⁸ cm⁻³ or less, preferably 1 × 10¹⁸ cm⁻³ or less.

As described above, when the GaN crystal 20 is grown on the main surface 10m, inclined at an angle α of 20° to 90° from the (0001) plane 10c, of the GaN seed crystal substrate 10, with the stacking fault density in the main surface 10m being 100 cm⁻¹ or less and the radius of curvature of the (0001) plane 10c being 5 m or more, by making a difference in impurity concentration of 3 10¹⁸ cm⁻³ or less between the GaN seed crystal substrate 10 and the GaN crystal 20, the GaN crystal 20 can be grown such that the crystal growth surface is the main surface 20m inclined at an angle α of 20° to 90° from the (0001) plane 20c and the stacking fault density in the main surface 20m is 100 cm⁻¹ or less.

Whereas the GaN crystal is grown on the main surface 10m of the single GaN seed crystal substrate 10 in the method for growing a GaN crystal according to this embodiment, GaN crystal may be grown on the main surfaces 10m of a plurality of GaN seed crystal substrate 10 arranged in a tile pattern to grow a large GaN crystal.

### Step of Cutting GaN Crystal Substrate from GaN Crystal

Next, a step of cutting a GaN crystal substrate from the GaN crystal 20 grown by the method for growing a GaN crystal according to this embodiment will be described with reference to Fig. 1C.

The GaN crystal 20 is cut along planes inclined at an angle α of 20° to 90° from the (0001) plane 20c to obtain GaN crystal substrates 20p, each having a main surface 20pm inclined at an angle α of 20° to 90° from the (0001) plane 20c. As described above, the GaN crystal substrates 20p cut from the GaN crystal 20, which has a stacking fault density of 100 cm⁻¹ or less in the crystal growth surface, namely, the main surface 20m, have a stacking fault density of 100 cm⁻¹ or less in the main surface 20pm.

### Second Embodiment

Referring to Fig. 1C, a GaN crystal substrate 20p according to a second embodiment of the present invention is cut from the GaN crystal 20 grown by the method for growing a GaN crystal according to the first embodiment. The main surface 20pm is inclined at an angle α of 20° to 90° from the (0001) plane 20c, and the stacking fault density in the main surface 20pm is 100 cm⁻¹ or less.

The method for forming the GaN crystal substrate 20p according to this embodiment is as described above in the first embodiment, and the description thereof will not be repeated.

The GaN crystal substrate 20p according to this embodiment is suitable for use in the production of semiconductor devices. In addition, the GaN crystal substrate 20p according to this embodiment can be used as an underlying substrate to further grow a GaN crystal thereon as in the first embodiment, and the resulting GaN crystal can be used to further produce GaN crystal substrates according to this embodiment.

The main surface 10m of the GaN crystal substrate 20p has low or no polarity, and the stacking fault density in the main surface 20pm is 100 cm⁻¹ or less. The GaN crystal substrate 20p can therefore be used to efficiently produce semiconductor devices having little or no shift in emission wavelength and decrease in luminous efficiency.

To further reduce, or eliminate, the polarity of the main surface 20pm of the GaN crystal substrate 20p, the main surface 20pm is preferably inclined at an angle α of 43° to 90° from the (0001) plane 20c.

To produce high-quality semiconductor devices more efficiently, the stacking fault density in the main surface 20pm of the GaN crystal substrate 20p is preferably 10 cm⁻¹ or less, more preferably 1 cm⁻¹ or less, and most preferably 0 cm⁻¹.

### Examples

### (Examples)

### 1. Preparation of GaN Seed Crystal Substrate

A 2 inch (50.8 mm) diameter GaN seed crystal was grown to a thickness of 30 mm on a GaN underlying crystal substrate having a main surface lying in the (0001) plane by HVPE. C-plane GaN seed crystal substrates having a thickness of 300 µm and having a main surface lying in the (0001) plane were then cut from the underlying substrate side and crystal growth surface side of the GaN seed crystal. In addition, a plurality of GaN seed crystal substrates 10 having a size of 25 mm × 25 mm × 300 µm in thickness and having main surfaces 10m inclined at predetermined angles α from the (0001) plane 10c so as to have the planar orientations shown in Tables I and II were cut from the portion between the underlying substrate side and the crystal growth surface side. These GaN seed crystal substrates 10 were mirror-polished on both main surfaces and were etched on both main surfaces and the four side surfaces to remove damaged portions.

The dislocation density in the main surface of the c-plane GaN seed crystal substrate cut from the underlying substrate side was measured to be 1 × 10⁶ cm⁻² by CL. The dislocation density in the main surface of the c-plane GaN seed crystal substrate cut from the crystal growth surface side was measured to be 7 × 10⁵ cm⁻² by CL. Hence, the dislocation densities of the GaN seed crystal substrates having the main surfaces 10m inclined at the respective angles α from the (0001) plane 10c were estimated to be 7 to 10 × 10⁵ cm⁻².

The radii of curvature of the (0001) plane of the c-plane GaN seed crystal substrates cut from the underlying substrate side and the crystal growth surface side were both measured to be 30 to 50 m by X-ray diffractometry. Hence, the radii of curvature of the (0001) plane of the GaN seed crystal substrates 10 having the main surfaces 10m inclined at the respective angles α from the (0001) plane 10c were estimated to be 30 to 50 m.

In low-temperature CL based on luminescence at 3.42 eV at an atmospheric temperature of 20 K, no stacking faults were observed in the main surface of any of the GaN seed crystal substrates 10 having the main surfaces 10m inclined at the respective angles α from the (0001) plane 10c (that is, the stacking fault density was 0 cm⁻¹).

The impurity concentrations of the GaN seed crystal substrates having the main surfaces 10m inclined at the respective angles α from the (0001) plane 10c were measured by SIMS. As a result, the oxygen atom concentration was 3 × 10¹⁶ cm⁻³ or less, the silicon atom concentration was 3 × 10¹⁶ cm⁻³ or less, and the carbon atom concentration fell below the detection limit (1 × 10¹⁶ cm⁻³).

### 2. Growth of GaN Crystal

GaN crystals 20 were grown to a thickness of 10 mm by HVPE on the main surfaces 10m of the above-described a plurality of GaN seed crystal substrates 10 inclined at the predetermined angles α from the (0001) plane 10c so as to have the planar orientations shown in Tables I and II. The crystal growth temperature (the temperature of the GaN seed crystal substrates 10) was adjusted to 1,050°C, and the crystal growth rate was adjusted to 100 µm/hr. Before the growth of the GaN crystals 20 by HVPE, the main surfaces 10m of the GaN seed crystal substrates 10 were etched with HCl gas by a thickness of about 0.5 µm to remove remaining damaged portion and dirt from the main surfaces 10m.

To reduce or adjust the impurity concentration (particularly, oxygen atom concentration) in the GaN crystals 20 grown by HVPE on the main surfaces 10m of the GaN seed crystal substrates 10 inclined at the predetermined angles α from the (0001) plane 10c, the following special apparatus and method were implemented.

A first finer tube 110 formed of high-purity (99.999% by mass) pBN was disposed in a reaction tube 102 formed of quartz glass. As a first purge gas, a high-purity (99.9999% by mass) nitrogen gas was allowed to flow between the reaction tube 102 and the first liner tube 110 through a first purge gas introduction pipe 103. In addition, a susceptor 140 supporting a GaN seed crystal substrate 10 disposed in the first finer tube 110 had a pBN-coated carbon heater as a local heating mechanism for locally heating the back surface of the GaN seed crystal substrate, and the surface of the susceptor 140 was coated with pBN. While the heating temperature of heaters 151, 152, and 153 for heating the reaction tube 102 was about 700°C, the temperature of the GaN seed crystal substrate 10 was increased to 1,050°C by the local heating mechanism. In addition, high-purity (99.9999% by mass) gallium (Ga source 30) was put in a gallium source boat 130 formed of quartz glass, and HCl gas (chlorine-containing gas) was introduced into the gallium (Ga source 30) in the gallium source boat 130 through a chlorine-containing gas introduction pipe 106 to generate GaCl gas (Ga source gas). At this time, the temperature of the gallium source boat 130 was set to be lower than usual, namely, to 700°C to 750°C. In addition, nitrogen (N₂) gas was used instead of hydrogen (H₂) gas as a carrier gas for the HCl gas (chlorine-containing gas) introduced into the gallium source boat 130. In addition, the gallium source boat 130 was disposed in a second liner tube 120 disposed in the first liner tube 110 and formed of high-purity (99.999% by mass) pBN, and nitrogen (N₂) gas was introduced as a second purge gas into the second liner tube 120 through a second purge gas introduction pipe 105. The impurity concentration (particularly, oxygen atom concentration) of the GaN crystal 20 to be grown was adjusted depending on the concentration of H₂O gas in the nitrogen (N₂) gas. In addition, nitrogen (N₂) gas was used instead of hydrogen (H₂) gas as a carrier gas for the HCl gas (chlorine-containing gas) introduced into the gallium source boat 130. In addition, ammonia (NH₃) gas, serving as a nitrogen source gas, and hydrogen (H₂) gas and nitrogen (N₂) gas, serving as carrier gases, were introduced into the first liner tube 110 through a nitrogen source gas introduction pipe 104 via the space between the first liner tube 110 and the second liner tube 120.

Thus, GaN crystals 20 having the oxygen atom concentrations (cm⁻³) shown in the columns of Tables I and II were grown to a thickness of 10 mm on the main surfaces 10m of plurality of the GaN seed crystal substrates 10 inclined at the predetermined angles α from the (0001) plane 10c so as to have the planar orientations shown in the rows of Tables I and II. The stacking fault densities (cm⁻¹) in the main surfaces, forming the crystal growth surfaces, of the resulting GaN crystals 20 are shown in the cells of the matrix tables in Tables I and II. All GaN crystals 20 had a silicon atom concentration of 3 × 10¹⁶ cm⁻³ or less and a carbon atom concentration below the detection limit (1 × 10¹⁶ cm⁻³).

**Table I**

| **GaN seed crystal substrate** | | **Oxygen atom concentration of GaN crystal (cm⁻³)** | | | |
|---|---|---|---|---|---|
| Planar orientation | Angle of inclination from (0001) plane | 1 × 10¹⁸ | 3 × 10¹⁸ | 5 × 10¹⁸ | 1 × 10¹⁹ |
| (0001) | 0° | 0 cm⁻¹ | 0 cm⁻¹ | 0 cm⁻¹ | 0 cm⁻¹ |
| (11-216) | 11° | 0 cm⁻¹ | 0 cm⁻¹ | 0 cm⁻¹ | 0.5 cm⁻¹ |
| (11-28) | 22° | 0 cm⁻¹ | 0 cm⁻¹ | 0.6 cm⁻¹ | 11 cm⁻¹ |
| (11-24) | 38° | 0 cm⁻¹ | 0 cm⁻¹ | 16 cm⁻¹ | 25 cm⁻¹ |
| (11-22) | 58° | 0 cm⁻¹ | 1 cm⁻¹ | 55 cm⁻¹ | 110 cm⁻¹ |
| (11-21) | 73° | 2 cm⁻¹ | 10 cm⁻¹ | 110 cm⁻¹ | 170 cm⁻¹ |
| (11-20) | 90° | 5 cm⁻¹ | 32 cm⁻¹ | 210 cm⁻¹ | 350 cm⁻¹ |

**Table II**

| **GaN seed crystal substrate** | | **Oxygen atom concentration of GaN crystal (cm⁻³)** | | | |
|---|---|---|---|---|---|
| Planar orientation | Angle of inclination from (0001) plane | 1 × 10¹⁸ | 3 × 10¹⁸ | 5 × 1018 | 1 × 10¹⁹ |
| (0001) | 0° | 0 cm⁻¹ | 0 cm⁻¹ | 0 cm⁻¹ | 0 cm⁻¹ |
| (10-18) | 13° | 0 cm⁻¹ | 0 cm⁻¹ | 0 cm⁻¹ | [0024] 0.5 cm⁻¹ |
| (10-14) | 25° | 0 cm⁻¹ | 0 cm⁻¹ | 0.7 cm⁻¹ | 12 cm⁻¹ |
| (10-12) | 43° | 0 cm⁻¹ | 1 cm⁻¹ | 32 cm⁻¹ | 55 cm⁻¹ |
| (20-21) | 15° | 1 cm⁻¹ | 6 cm⁻¹ | 120 cm⁻¹ | 180 cm⁻¹ |
| (10-10) | 90° | 5 cm⁻¹ | 32 cm⁻¹ | 210 cm⁻¹ | 350 cm⁻¹ |

As shown in Tables I and II, the GaN crystals grown on the main surfaces of the GaN seed crystal substrates inclined at an angle of 20° to 90° from the (0001) plane, in which the GaN seed crystal substrates and the GaN crystals had a difference in impurity concentration of 3 × 10¹⁸ cm⁻³ or less, had significantly lower stacking fault densities, and the GaN crystals grown such that the GaN seed crystal substrates and the GaN crystals had a difference in impurity concentration of 1 × 10¹⁸ cm⁻³ or less had further significantly lower stacking fault densities.

Whereas the GaN crystals in the above examples were each grown on a main surface of a single GaN seed crystal substrate, similar results were obtained when GaN crystal was grown on main surfaces composed of a plurality of GaN seed crystal substrates arranged in a tile pattern to grow a large GaN crystal.

The embodiments and examples disclosed herein should be construed as illustrative, rather than as limiting, in all respects. The scope of the present invention is defined by the claims, rather than by the above description, and it is intended that all modifications within the meaning and scope of the claims and equivalents thereof be included.

### Reference Signs List

10 GaN seed crystal substrate
10c, 20c (0001 1) plane
10m, 20m, 20pm main surface
20 GaN crystal
20p GaN crystal substrate
30 Ga source
100 HVPE apparatus
101 reaction chamber
102 reaction tube
103 first purge gas introduction pipe
104 nitrogen source gas introduction pipe
105 second purge gas introduction pipe
106 chlorine-containing gas introduction pipe
107 gallium source gas introduction pipe
109 gas discharge pipe
110 first liner tube
120 second liner tube
130 gallium source boat
140 susceptor
151, 152, 153 heaters

## Claims

1. A method for growing a GaN crystal, comprising the steps of:
preparing a GaN seed crystal substrate having a main surface inclined at an angle of 20° to 90° from a (0001) plane; and
growing a GaN crystal on the GaN seed crystal substrate;
wherein the GaN seed crystal substrate and the GaN crystal have a difference in impurity concentration of 3 × 10¹⁸ cm⁻³ or less.

2. The method for growing a GaN crystal according to Claim I, wherein the main surface of the GaN seed crystal substrate is inclined at an angle of 43° to 90° from the (0001) plane.

3. The method for growing a GaN crystal according to Claim I or Claim 2, wherein the GaN seed crystal substrate and the GaN crystal have a difference in impurity concentration of 1 × 10¹⁸ cm⁻³ or less.

4. The method for growing a GaN crystal according to any one of claims 1 through 3, wherein the impurity concentration of the GaN seed crystal substrate and the GaN crystal is oxygen atom concentration.

5. The method for growing a GaN crystal according to any one of claims 1 through 4, wherein the stacking fault density in the main surface of the GaN seed crystal substrate is 100 cm⁻¹ or less, and the radius of curvature of the (0001) plane is 5 m or more.

6. A GaN crystal substrate cut from the GaN crystal grown by the method for growing a GaN crystal according to any one of claims 1 through 5, the GaN crystal substrate having a main surface inclined at an angle of 20° to 90° from a (0001) plane, wherein the stacking fault density in the main surface is 100 cm⁻¹ or less.
